# EUROPEAN PATENT APPLICATION

(11) **EP 3 470 857 A1**
(43) Date of publication of application: **17.04.2019**
(21) Application number: 17001660.4
(22) Date of filing: 10.10.2017
(51) Int. Cl.: G01R 31/28

(54) **PRESS ASSEMBLY FOR AN IN-CIRCUIT TESTER**

(71) Applicant: Fitech sp. z o.o., 34-200 Sucha Beskidzka (PL)
(72) Inventor: Bogdan, Arkadiusz, 34-322 Gilowice (PL); Lesniak, Adam, 34-200 Sucha Beskidzka (PL); Kot, Krzysztof, 34-212 (PL)
(74) Representative: Lukaszyk, Szymon

(57) **Abstract**

The invention relates to displacement arrangement (1) of a push elements (41) arrangement (4) of a system for testing printed circuit boards (PCB), in particular printed circuit board assemblies with electronic components (PCBA), which comprises:
- a mechanical frame (2) comprising:
- a mounting board (3) configured for mounting thereon a push plate (4) provided with a number of nonconductive push elements (41);
- a base plate (5) positioned parallelly relative to said mounting board (3), wherein a ball nut (51) is mounted in the central area of said base plate (5), and said base plate (5) is connected to said mounting board (3) by means of connecting profiles (6) which are parallel with each other and perpendicular relative to said base plate (5), wherein at the external side of each connecting profile (6) at least two rolling carriages (61) of linear guides are installed positioned collinearly in relation to each other along an axis that is parallel relative to the longitudinal axis (O) of a translation ball screw (52) screwed in said ball nut (51);
- mounting guides (31) of said push plate (4) located on the surface of said mounting board (3) at the side of said base plate (5) and defining mounting channels (32) into which edge areas of said push plate (4) are inserted;
- blockages (33) blocking a displacement of said push plate (4) in said mounting channels (32);
- detectors (34) of locking said blockages (33);
- two pairs of pressure elements (36) protruded from said mounting plate (3) toward said base plate (5) and arranged along two straight lines which are parallel with each other and run between the opposite pairs of said connecting profiles (6), and

- a translation ball screw (52) that is immobilized on the direction of its longitudinal axis (O), screwed in said ball nut (5) and coupled with said power transmission system (7) in a manner providing a rotation of said translation ball screw (52) about its longitudinal axis (O) in both rotation directions.

## Description

The present invention relates to a displacement arrangement of a push element arrangement of a system for testing printed circuit boards, in particular printed circuit board assemblies with electronic components.

### Background of the Invention

From a prior art, systems and devices for testing printed circuit boards (PCB), including printed circuit board assemblies with electronic components (PCBA), are known which comprise:
- a measurement plate provided with a number of conductive measurement probes which are connected to a system of an analysis of electrical parameters of circuit elements of a PCB/PCBA assembly; and
- a push plate provided with a number of nonconductive push elements which is positioned in parallel relative to the measurement plate and coupled with a power transmission system enabling for reciprocatory displacing of the push plate relative to the measurement plate in the direction perpendicular in relation to the planes of these plates, in order to push a PCB/PCBA assembly to be tested to the measurement probes by means of the push elements.

Push elements, typically in a form of push pins, push onto a PCB/PCBA assembly surface that is opposite relative to the surface onto which the measurement probes press, and in this manner prevent against PCB/PCBA assembly deformations which would result in a consequence of pressing on a PCB/PCBA plate solely by the measurement probes at only one side of the plate. Thanks to that, a formation of mechanical damages of PCB/PCBA assemblies under test and furthermore a good electrical contact of measurement probes with a measurement fields on a PCB/PCBA assembly is ensured.

For testing a given PCB/PCBA assembly, a measurement plate appropriately configured and structured for this given PCB/PCBA assembly and having measurement probes that are appropriately distributed and have appropriate lengths, has to be employed, and furthermore a push plate has to be used which is matched up to this given PCB/PCBA assembly and provided with push elements distributed appropriately for this given PCB/PCBA assembly and in consideration of a distribution of measurement probes. In a typical case, a push element distribution on a push plate reflects a distribution of measurement probes of a measurement plate. Therefore a displacement arrangement of a push element arrangement of a system for testing PCB/PCBA assemblies should ensure a possibility of a replacement of a push plate, and furthermore preferably should hinder a push plate replacement as little as possible.

In known solutions for displacing a push plate, a displacement arrangement is used comprising four translation screws that are screwed in nuts fixed in the corners of a rectangular push plate or mounting plate on which a replaceable push plate is fastened. Solutions of this type are disclosed for example in the patent publications EP0475614, US12/576,656 or US4818933. Furthermore, a solution of this kind has been implemented in a commercially available tester J401-03 manufactured by JOT Automation, in which clamping of a PCB/PCBA board is effected by means of four ball screws translocating a push plate.

Though such known displacement arrangements comprising four translation screws fulfill demands with respect to a displacing of a push plate, they require however special intricate solutions ensuring a smoothness a push plate displacement, such as for example a complex system for controlling four servomotors propelling individual screws or a complicated power transmission system ensuring an even distribution of power onto all screws.

Therefore it has been the object of the present invention to provide a displacement arrangement of a push element arrangement of a system for testing PCB/PCBA assemblies, which would feature a simple construction though providing operational reliability as well as an accuracy of a displacement of a push plate with push elements.

### Summary of the Invention

The invention provides a displacement arrangement of a push element arrangement of a system for testing printed circuit boards, in particular for testing printed circuit board assemblies with electronic components which comprises
- a mechanical frame comprising
   - a mounting board configured for mounting thereon a push plate provided with a number of nonconductive push elements;
   - a base plate positioned parallelly relative to said mounting board, wherein a ball nut is mounted in the central area of said base plate, and said base plate is connected to said mounting board by means of connecting profiles which are parallel with each other and perpendicular relative to said base plate, wherein at the external side of each connecting profile at least two rolling carriages of linear guides are installed positioned collinearly in relation to each other along an axis that is parallel relative to the longitudinal axis of a translation ball screw screwed in said ball nut;
   - mounting guides of said push plate located on the surface of said mounting board at the side of said base plate and defining mounting channels into which edge areas of said push plate are inserted;
   - blockages blocking a displacement of said push plate in said mounting channels;
   - detectors of a locked state of said blockages;
   - two pairs of pressure elements protruded from said mounting plate toward said base plate and arranged along two straight lines which are parallel with each other and run between the opposite pairs of said connecting profiles, and
- a translation ball screw that is immobilized on the direction of its longitudinal axis, screwed in said ball nut and coupled with said power transmission system in a manner providing a rotation of said translation ball screw about its longitudinal axis in both rotation directions.

Rotation of the translation ball screw of the displacement arrangement according to the present invention provides a reciprocatory dislocation of the mechanical frame, and thus a reciprocating dislocation of the push plate installed on the mounting plate, relative to a measurement plate placed inside the mechanical frame and positioned in parallel relative to the mounting plate, and furthermore enables for pressing a PCB/PCBA assembly to be tested against measurement probes of a measurement plate by means of the push elements of the push plate.

The mounting guides of the push plate may have a form of profiles parallel to each other and provided with longitudinal protrusions defining said mounting channels between them and the surface of the mounting plate.

Said blockage blocking a displacement of said push plate in said mounting channels ensures a reliable fixation of said push plate in the mechanical frame of the displacement arrangement of the present invention, and may for example comprise quick-closing toggle clamps, such as for example toggle clamps Rais 901, in which a locking element in the clamp closed state is positioned on the axis of the mounting channel outlet.

As exemplary detectors of a locked state of the blockages according to the present invention, appropriately distributed proximity sensors may be employed which signals for example a position state of a blocking element of a quick-closing toggle clamp. Said detector of a locked state of the blockage is preferably encased in an additional mechanical enclosure that prevents against a damage of the detector.

Said pressure elements may preferably form of cylindrical pressure pins of the same length which protrude perpendicularly from said mounting plate and are distributed over this mounting plate along the opposite edge regions thereof. Said pressure elements serve for pressing on profiles of a transport system of transporting PCB/PCBA assemblies to be tested, wherein in a complete system for testing PCB/PCBA assemblies such a transport system runs through the interior of the mechanical frame of the displacement arrangement of the present invention between said mounting plate and said base plate and through windows defined between said connecting profiles. In a result of displacement of said mechanical frame, said pressure elements cause the transport system to be dropped down and thus a PCB/PCBA assembly to be settled down on measuring probes of a measurement plate positioned also in the interior of said mechanical frame between said base plate and said push plate installed on said mounting plate.

In preferred embodiments of the displacement arrangement of the present invention
- said mounting plate and said base plate have the same rectangular shapes and are connected with each another by means of four connecting profiles having form of slats fixed in the corners in pairs to the opposite side surfaces of said mounting plate and said base plate;
- said rolling carriages are installed on the connecting slats surfaces that are opposite relative to the contact surfaces of the connecting slats with said mounting plate and said base plate,
- said mounting plate has an internal through opening in the area between said mounting guides of said push plate,
- said base plate has two edge through openings which are open at the side surfaces of the base plate, wherein said connecting slats are fastened to said side surfaces, and
- said displacement arrangement additionally comprises at least one wire guide chain fastened to the mounting plate in the area of the projection of said edge through opening of the base plate wherein said projection is projected on the direction of the axis of said translation ball screw.

Said internal opening of said mounting plate located above the place of an installation of said push plate in the mounting plate provides an access to openings formed in the push plate enabling for an additional acquisition of data related with a PCB/PCBA assembly under test using vision technologies. Said push plate is most commonly made of transparent plastic (usually of poly(methyl methacrylate)), whereby, through said internal through opening of said mounting plate, a visional testing for example of a correctness of lighting of LED diodes on the top surface of a PCB/PCBA assembly may be effected.

Said wire guide chains ensure a safe conveying of power supply cables and/or signal cables to electrical and electronical elements installed on the mounting plate.

The present invention constitutes a relatively simple mechanical solution realized using solely one translation ball screw. The construction of said mechanical frame of the displacement arrangement according to the present invention is rigid, provides a parallelism of a working surfaces and a facility of a replacement of said push plate and further a good accessibility to a measurement plate and thus also a facility of a replacement of a measurement plate. The displacement arrangement of the present invention features a relatively small inertia and enables for displacing said push plate with a relatively high speed, an infinitely variable adjustment of a push force, a scalable control of a position of said push plate what is important in a case of measurement probes of different length and enables for connecting consecutive measurement points in sequence. Furthermore, the displacement arrangement according to the present invention may be efficiently controlled with a high precision using a simple control system.

### Brief description of drawings

The invention shall be described and explained below in connection with the attached schematic drawings on which:
Fig. 1 is a schematic front view of an embodiment of a displacement arrangement of push elements arrangement according to the present invention, and
fig. 2 is an axonometric view the mechanical frame of the displacement arrangement as depicted in Fig. 1.

### Detailed description of preferred embodiments

The depicted embodiment of the displacement arrangement 1 of an arrangement 4 of push elements 41 of a device for testing PCB/PCBA assemblies comprises a mechanical frame 2 installed by means of a ball nut 51 on a single one translation ball screw 52 coupled with a power transmission system 7.

The main components of the frame 2 are a mounting plate 3 and a base plate 5 connected with each other by means of four connecting profiles 6. The mounting plate 3 and the base plate 5 are parallel in relation to each other and have the same rectangular shapes. All connecting profiles 6 are parallel in relation to each other and perpendicular relative to the mounting plate 3 and the base plate 5. The connecting profiles 6 have a form of connecting slats fixed in pairs in the corners to the opposite side surfaces of the mounting plate 3 and the base plate 5. Furthermore, at the inner sides of the connecting slats 6, the mounting plate 3 and the base plate 5 are connected with each other by means of tubular reinforcing connecting profiles 62 of a square cross-section. The slats 6 are additionally joint to the reinforcing profiles 62 forming a construction of a T-shaped cross-section featuring a high rigidity. At the external sides of the connecting slats 6 that are opposite relative to contact surfaces of these slats 6 with the mounting plate 3 and the base plate 5, there are installed pairs of rolling carriages 61. The rolling carriages 61 are located on the terminal regions of the connecting slats 6 and positioned collinearly in relation to each other along the axes that are parallel relative to the longitudinal axis O of a translation ball screw 52 screwed in the ball nut 51. Into the channels of the rolling carriages 61 in which rolling elements are located (usually bearing balls), rolling rails (not shown in the figures) are introduced that together with the carriages 61 create linear guides ensuring a precise dislocation of the frame 2 along the longitudinal axis O of the translation ball screw 52, operatively without generating a transverse load on the coupling of the translation ball screw 52 with the ball nut 51 and the power transmission system 7.

At the external surface of the mounting plate 3, from the side of the base plate 5, mounting guides 31 are installed in parallel to each other. The mounting guides 31 define mounting channels 32 into which the edge regions of the push plate 4 are inserted. The mounting guides 31 are also parallel relative to the base plate 3 side surfaces to which the connecting slats 6 are fastened. In the presented embodiment, the mounting guides 31 comprise longitudinal protrusions 311 defining the mounting channels 31 between them and the surface of the mounting plate 3.

Blockages 33 are installed in the region of the outlets of the mounting channels 32 which block a displacement of the push plate 4 out of the mounting channels 32. In the presented embodiment, the blockages 33 comprise horizontal quick-closing toggle clamps, such as for example commercially available toggle clamps Rais 901, in which a locking element in the clamp closed state is positioned on the axis of the mounting channel 32 outlet.

Furthermore, the mechanical frame 2 comprises detectors 34 of a locked state of said blockages 33 which are installed on the mounting plate 3. In the presented embodiment, the detectors 34 are proximity sensors signaling position states of blocking elements of the toggle clamps 33. The detectors 34 are encased in additional mechanical enclosures 35 fixed on the reinforcing profiles 62 and preventing against damages of the detectors 34.

Four pressure elements 36 protrude from the mounting plate 3 toward the base plate 5. The pressure elements 36 have a form of cylindrical pressure pins arranged in pairs along two straight lines parallel with each other and running between the opposite pairs of said connecting profiles 6 perpendicularly relative to the mounting channels 32 of the push plate 4. The pressure pins 36 are located in the edge regions of the mounting plate 3 at the external side of the mounting guides 31 between the reinforcing profiles 62. The pressure pins 36 serves for pressing onto a low-profile moveable conveyor 8 of a device for testing PCB/PCBA assemblies in order to dislocate the conveyor 8 in relation to the measurement plate 91.

In the central region of the mounting plate 3, between the mounting guides 31, an internal through opening 37 is formed. Whereas in the base plate 5, two opposite rectangular edge through openings 53 are formed open at the side surfaces of the base plate 5 to which the connecting slats 6 are fixed. Wire guide chains 38 runs through the edge openings 53 of the base plate 5 and are fastened to the mounting plate 3 in the regions of the projections of the edge through openings 53 of the base plate 5, wherein the projections are projected along the direction of the longitudinal axis O of said translation ball screw 52.

From the mounting plate 3 in the area between the mounting guides 31, a channel section bracket 39 protrudes additionally from the side of the base plate 5, wherein on the channel section bracket 39 an adapter 391 is fixed apt for installing a socket of a coding interface (not shown in the figures) thereon. The coding interface socket serves for receiving a corresponding coding interface plug which is installed in the push plate 4 inserted into the mounting guides 31. The configuration of a coding interface plug of a given push plate 4 has to be appropriate for a given measurement plate 91 that is mounted in the adapter 9 what is software-confirmed by a software installed in the device for testing PCB/PCBA assemblies. A recognition of a correctness of a coding interface plug affirms a compatibility of a given push plate 4 with a given measurement plate 91 and ensures a lack of mechanical damage of a tested PCB/PCBA assembly in a result of its compression with a push plate incompatible with a given measurement plate. Additionally two brackets 310 protrude from the mounting plate 3 toward the base plate 5 provided with frames for mounting electric-pneumatic/hydraulic interfaces (not shown in the figures), such as for example electro-pneumatic interfaces manufactured by HARTING, used for supplying suitable electric signals and pneumatic/hydraulic signals to the push plate 4, wherein such signals may be used for example for testing PCB/PCBA assemblies comprising a potentiometer at the top side.

In the central region of the base plate 5, the ball nut 51 is installed in a pass-through manner, and the translation ball screw 52 is screwed in this ball nut 51. The translation ball screw 52 is coupled with the power transmission system 7 in a manner providing that the screw 52 is immobilized on the direction of its longitudinal axis O.

In the presented embodiment, the power transmission system 7 comprises servomotor 71 which by means of an angle drive 72 and a clutch arrangement 73 rotates the translation ball screw 52 about its longitudinal axis O in the required direction. Rotating the translation ball screw 52 causes, depending on the direction of rotation, a linear displacement of the mechanical frame 2 toward or away from the translation ball screw 52. For a skilled technician it is obvious that for the purposes of the present invention any different arbitrary power transmission system may be employed.

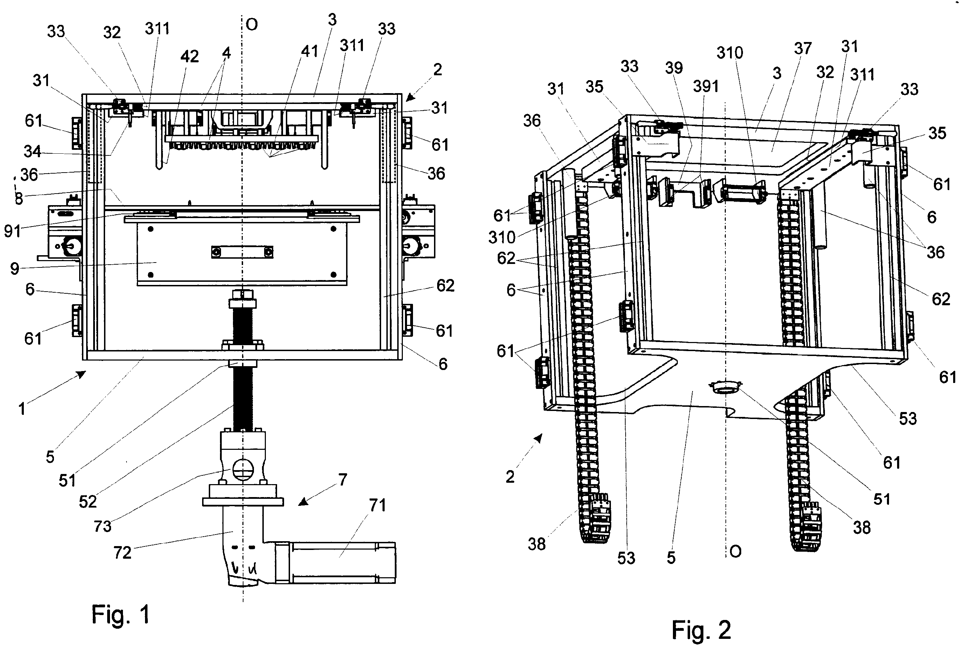

Fig. 1 schematically presents the displacement arrangement 1 of the present invention together with certain other components of a device for testing PCB/PCBA assemblies including the push plate 4, the horizontal low-profile moveable conveyor 8 and the adapter 9 with the measurement plate 91. The push plate 4 is inserted into the mounting channels 32 of the push plate 3 of the frame 2 and comprises a number of the push pins 41 and positioning pins 42 projected from the push plate 4 toward the measurement plate 91 positioned in the interior of the frame 2 on the adapter 9. The adapter 9 serves for mounting a replaceable measurement plate 91 and for electrical coupling of its measurement probes with input/output devices of a system of an analysis of electrical parameters of a PCB/PCBA components. The low-profile linear conveyor 8 runs through the interior of the frame 2 between the push plate 4 and the measurement plate 91 on the direction of the longitudinal axis O of the translation ball screw 52 in the planes passing through the lines of the pressure pins 36 distribution. The low-profile moveable conveyor 8 may be dislocated in a parallel manner toward the measurement plate 91 and below the level of the measurement plate 91 probes on the direction of the longitudinal axis O of the translation ball screw 52, wherein after such a dislocation the conveyor 8 automatically returns to the initial position above the measurement plate 91. After an appropriate positioning the PCB/PCBA assembly to be tested on the moveable conveyor 8 over the measurement plate 91, the translation ball screw 52 starts to be rotated in the direction resulting in dislocating the whole mechanical frame 2 with the push plate 4 along the longitudinal axis O toward the PCB/PCBA assembly and the measurement plate 91. During such a dislocation of the frame 2, the pressure pins 36 start to press on the moveable conveyor 8 and further dislocate the conveyor 8 below the level of the measurement probes what results in settling the PCB/PCBA assembly down on the measurement probes projected from the measurement plate 91. Before the PCB/PCBA assembly becomes settled on the probes, the positioning pins 42 are inserted into corresponding positioning openings formed in the PCB/PCBA assembly and in the measurement plate 91 thus providing an appropriate intermutual positioning of the measurement fields on the PCB/PCBA assembly, the measurement probes on the measurement plate 91 and the push pins 41 on the push plate 4 in relation to one another. After obtaining a proper push force, rotating the translation ball screw 52 is stopped and a test of the PCB/PCBA assembly is carried out. After a completion of the test, the translation ball screw 52 is rotated in the opposite direction and thus the frame 2 returns to its initial position and the PCB/PCBA assembly is lifted up from the measurement plate 91 by the moveable conveyor 8 which also returns to its initial position.

Taking into account a possibility of developing a number of further embodiments of the present invention, different from the above described embodiment as presented in the figures, in particular modifications and variants of the above described embodiment, the above presented embodiment should be regarded merely as exemplary and not limiting the scope of protection defined in the patent claims.
The figures are not necessarily to scale, and some features may be exaggerated or minimized. These and other factors however should not be considered as limiting the spirit of the invention, the intended scope of protection of which is indicated in the appended claims.

### List of reference numerals

| | | | |
|---|---|---|---|
| 1 | a displacement arrangement | 38 | a wire guide chain |
| 2 | a mechanical frame | 39 | a bracket of the coding interface socket adapter |
| 3 | a mounting plate | | |
| 31 | mounting guides (of the pusher plate 4) | 391 | an adapter of a coding interface socket |
| 310 | a bracket of an electric-pneumatic/hydraulic interface | 4 | a push plate |
| | | 41 | push elements (push pins) |
| 311 | a longitudinal protrusion (of the guide 31) | 42 | positioning pins |
| | | 5 | a base plate |
| 32 | a mounting channel (for the push plate 4) | 51 | a ball nut |
| | | 52 | a translation ball screw |
| 33 | a blockage (a quick-closing toggle clamp) | 53 | an edge through opening |
| | | 6 | connecting profiles (slats) |
| 34 | a detector of a locked state of the blockage (a proximity sensor) | 61 | a rolling carriage |
| | | 62 | reinforcing profiles |
| | | 7 | a power transmission system |
| 35 | mechanical enclosure (of the detector 34) | 71 | a servomotor |
| | | 72 | an angle drive |
| 36 | pressure elements (pressure pins) | 73 | a clutch arrangement |
| | | 8 | a low-profile moveable conveyor |
| 37 | an internal through opening | 9 | an adapter |
| | | 91 | a measurement plate |

## Claims

1. A displacement arrangement (1) of a push element (41) arrangement (4) of a system for testing printed circuit boards (PCB), in particular printed circuit board assemblies with electronic components (PCBA), which comprises:
- a mechanical frame (2) comprising:
- a mounting board (3) configured for mounting thereon a push plate (4) provided with a number of nonconductive push elements (41);
- a base plate (5) positioned parallelly relative to said mounting board (3), wherein a ball nut (51) is mounted in the central region of said base plate (5), and said base plate (5) is connected to said mounting board (3) by means of connecting profiles (6) which are parallel with each other and perpendicular relative to said base plate (5), wherein at the external side of each connecting profile (6) at least two rolling carriages (61) of linear guides are installed and positioned collinearly in relation to each other along an axis that is parallel relative to the longitudinal axis (O) of a translation ball screw (52) screwed in said ball nut (51);
- mounting guides (31) of said push plate (4) located on the surface of said mounting board (3) at the side of said base plate (5) and defining mounting channels (32) into which the edge areas of said push plate (4) are inserted;
- blockages (33) blocking a displacement of said push plate (4) in said mounting channels (32);
- detectors (34) of a locked state of said blockages (33);
- two pairs of pressure elements (36) protruded from said mounting plate (3) toward said base plate (5) and arranged along two straight lines which are parallel with each other and run between the opposite pairs of said connecting profiles (6), and
- a translation ball screw (52) that is immobilized on the direction of its longitudinal axis (O), screwed in said ball nut (5) and coupled with said power transmission system (7) in a manner providing a rotation of said translation ball screw (52) about its longitudinal axis (O) in both rotation directions.

2. The displacement arrangement (1) according to Claim 1, **characterized in that**
- said mounting plate (3) and said base plate (5) have the same rectangular shapes and are connected with each another by means of four connecting profiles (6) having form of slats fixed in pairs in the corners to the opposite side surfaces of said mounting plate (3) and said base plate (5);
- said rolling carriages (61) are installed on the connecting slats (6) surfaces that are opposite relative to the contact surfaces of the connecting slats (6) with said mounting plate (3) and said base plate (5),
- said mounting plate (3) has an internal through opening (37) in the area between said mounting guides (31) of said push plate (4),
- said base plate (5) has two edge through openings (53) which are open at the side surfaces of the base plate (5), wherein said connecting slats (6) are fastened to said side surfaces, and
- said displacement arrangement (1) additionally comprises at least one wire guide chain (38) fastened to the mounting plate (3) in the area of the projection of said edge through opening (53) of the base plate (5) wherein said projection is projected on the direction of the longitudinal axis (O) of said translation ball screw (52).
